# EUROPÄISCHE PATENTSCHRIFT

(11) **EP 3 845 045 B1**
(45) Veröffentlichungstag und Bekanntmachung des Hinweises auf die Patenterteilung: **18.02.2026**
(21) Anmeldenummer: 19755282.1
(22) Anmeldetag: 09.08.2019
(51) Int. Cl.: H05K 7/14

(54) **ELEKTROGERÄT, AUFWEISEND EIN ANSCHLUSSTEIL UND EIN MIT DEM ANSCHLUSSTEIL VERBUNDENES DECKELTEIL**
ELECTRICAL DEVICE, COMPRISING A CONNECTION PART AND A COVER PART CONNECTED TO THE CONNECTION PART
APPAREIL ÉLECTRIQUE COMPRENANT UNE PARTIE CONNEXION ET UNE PARTIE COUVERCLE RELIÉE À CETTE PARTIE CONNEXION

(30) Priorität: 27.08.2018 DE 102018006722
(43) Veröffentlichungstag der Anmeldung: 07.07.2021
(73) Patentinhaber: SEW-EURODRIVE GmbH & Co. KG, 76646 Bruchsal (DE)
(72) Erfinder: DAMINGER, Franz, 67067 Ludwigshafen am Rhein (DE); MAYER, Ralph, 76698 Ubstadt-Weiher (DE)
(86) Internationale Anmeldenummer: PCT/EP2019/025265
(87) Internationale Veröffentlichungsnummer: WO 2020/043324

(56) Entgegenhaltungen:
- WO-A1-99/14995
- DE-A1- 19 704 226

## Beschreibung

Die Erfindung betrifft ein Elektrogerät, aufweisend ein Anschlussteil und ein mit dem Anschlussteil verbundenes Deckelteil.

Es ist allgemein bekannt, dass mit einem als Umrichter fungierenden Elektrogerät ein Elektromotor drehzahlgeregelt betreibbar ist.

**Aus der** WO 99/14995 A1 **ist als nächstliegender Stand der Technik ein elektrisches Gerät mit einem Justierelement bekannt.**

**Aus der** DE 197 04 226 A1 **ist ein Elektromotor mit vorgeschaltetem Frequenzumrichter bekannt.**

Der Erfindung liegt daher die Aufgabe zugrunde, ein Elektrogerät weiterzubilden, wobei **Fehler verringerbar sind.**

Erfindungsgemäß wird die Aufgabe bei dem Elektrogerät nach den in Anspruch 1 angegebenen Merkmalen gelöst.

Wichtige Merkmale der Erfindung bei dem Elektrogerät, dass es ein Anschlussteil und ein mit dem Anschlussteil verbundenes Deckelteil, insbesondere ein auf das Anschlussteil aufgesetztes und verbundenes Deckelteil, aufweist,
wobei im Anschlussteil ein Aufnahmeteil aufgenommen und angeordnet ist, wobei mit dem Aufnahmeteil eine erste Leiterplatte kodiert verbunden ist,
wobei im Deckelteil eine zweite Leiterplatte angeordnet ist, welche mit einem Rahmenteil kodiert verbunden, insbesondere bestückt, ist,
wobei die erste Leiterplatte mit einem Steckverbinderteil verbunden, insbesondere bestückt, ist,
wobei die zweite Leiterplatte mit einem Gegensteckverbinderteil verbunden, insbesondere bestückt, ist,
wobei am Aufnahmeteil eine voreilende Führung für eine Steckverbindung ausgeformt ist, die beim Verbinden des Deckelteils mit dem Anschlussteil wirksam wird, insbesondere das
Deckelteil beim Aufsetzen auf das Anschlussteil führt, bevor das Steckverbinderteil mit dem Gegensteckverbinderteil in Kontaktverbindung kommt,
wobei das Rahmenteil kodiert verbindbar ist, insbesondere verbunden ist, mit dem Aufnahmeteil.

Von Vorteil ist dabei, dass infolge der Kodierungen eine Fehlverdrahtung oder fehlerhafte Zuordnung vermeidbar ist. Außerdem ist das Aufsetzen des Deckelteils auf das Anschlussteil voreilend geführt. Die Steckverbindung sowie die Kodierung ist also ohne Verkantung aktivierbar.

Bei einer vorteilhaften Ausgestaltung sind die kodierten Verbindungen jeweils durch mit Ausnehmungen, wie Schlitze oder Löcher, in Wirkverbindung stehende Codiernasen gebildet. Von Vorteil ist dabei, dass die Kodierungen in einfacher Weise bewirkbar sind.

Bei einer vorteilhaften Ausgestaltung weist das Aufnahmeteil an einer ersten Seite des Aufnahmeteils hervorstehende Codiernasen auf und weist an der zur ersten Seite gegenüberliegenden Seite hervorstehende Codiernasen auf,
insbesondere wobei die Codiernasen jeweils quer zur Steckverbindungsrichtung derjenigen Steckverbindung am Aufnahmeteil hervorragen, welche das Steckverbinderteil und das Gegensteckverbinderteil aufweist. Von Vorteil ist dabei, dass eine beidseitige Verbindung kodierbar ist. Außerdem ist somit das Steckverbinderteil in Steckverbindung von der Leiterplatte hervorragend ausrichtbar. Die Kodierung zwischen Aufnahmeteil und Leiterplatte ist somit beim Verbinden der Leiterplatte mit dem Aufnahmeteil quer zur Steckverbindungsrichtung wirksam. Hingegen ist die andere am Aufnahmeteil gegenüberliegende Kodierung parallel zur Steckverbindungsrichtung wirksam.

Bei einer vorteilhaften Ausgestaltung ist die voreilende Führung als am Aufnahmeteil hervorragende Führungsnase ausgeformt. Von Vorteil ist dabei, dass das Verkanten einfach verhinderbar ist.

Bei einer vorteilhaften Ausgestaltung sind zur kodierten Verbindung des Aufnahmeteils mit der ersten Leiterplatte am Aufnahmeteil Codiernasen ausgeformt, welche in oder durch

Ausnehmungen der ersten Leiterplatte ragen. Von Vorteil ist dabei, dass die Kodierung kostengünstig realisierbar ist.

Bei einer vorteilhaften Ausgestaltung sind zur kodierten Verbindung des Rahmenteils mit der zweiten Leiterplatte an dem Rahmenteil Codiernasen ausgeformt, welche in oder durch Ausnehmungen der zweiten Leiterplatte ragen. Von Vorteil ist dabei, dass die Kodierung kostengünstig realisierbar ist.

Bei einer vorteilhaften Ausgestaltung sind zur kodierten Verbindung des Rahmenteils mit dem Aufnahmeteil am Aufnahmeteil Codiernasen ausgeformt, welche in Schlitze des Rahmenteils hineinragen. Von Vorteil ist dabei, dass die Kodierung kostengünstig realisierbar ist.

Bei einer vorteilhaften Ausgestaltung sind das Rahmenteil und das Aufnahmeteil jeweils als Kunststoffspritzgussteil gefertigt. Von Vorteil ist dabei, dass eine einfache kostengünstige Herstellung ermöglicht ist und die Kodierung ohne besonderen aufwand realisierbar ist.

Bei einer vorteilhaften Ausgestaltung ist das Elektrogerät ein Umrichter und/oder weist einen Wechselrichter auf, der einen Elektromotor speist, an dem das Anschlussteil befestigt ist. Von Vorteil ist dabei, dass ein kompakter Umrichtermotor ausbildbar ist.

Bei einer vorteilhaften Ausgestaltung fungiert eine im Deckelteil auf die zweite Leiterplatte angeordnete elektronische Schaltung als Elektronik eines Umrichters oder Wechselrichters,
insbesondere welcher mittels ins Anschlussteil geführter Drehstromleitungen gespeist ist und dessen einen Elektromotor speisender elektrischer Anschluss über Kontakte des Steckverbinderteils und aus dem Anschlussteil herausgeführte, zum Elektromotor geführte Leitungen mit dem Anschluss des Elektromotors elektrisch verbunden ist. Von Vorteil ist dabei, dass der Elektromotor drehzahlgeregelt betreibbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

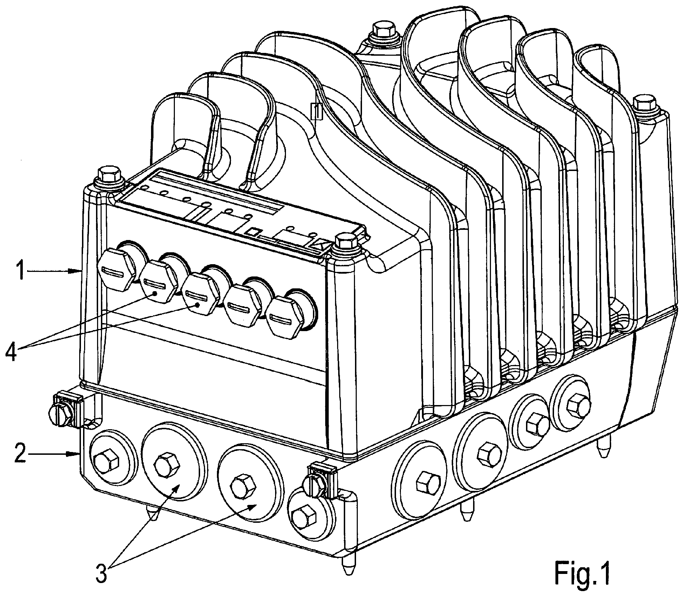

In der Figur 1 ist ein Elektrogerät, umfassend ein auf ein Anschlussteil 2 aufgesetztes Deckelteil 1, in Schrägansicht. dargestellt.

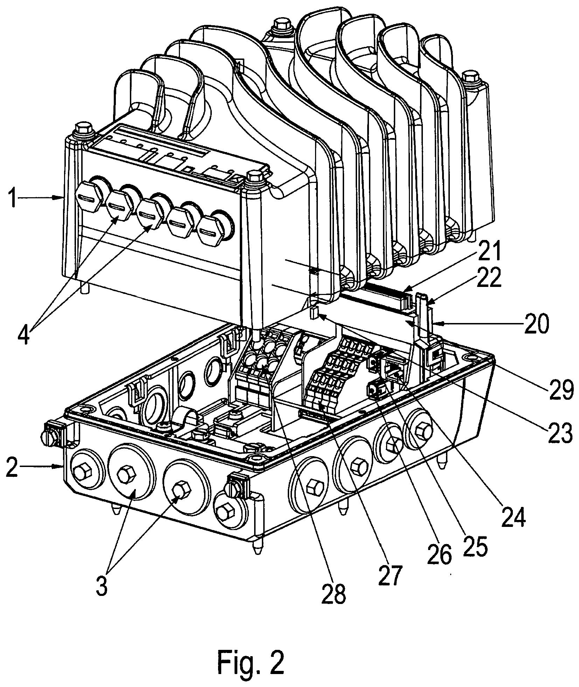

In der Figur 2 ist das Elektrogerät explodiert und in Schrägansicht dargestellt, wobei ein im Anschlussteil 2 angeordnetes Aufnahmeteil 20 sichtbar ist.

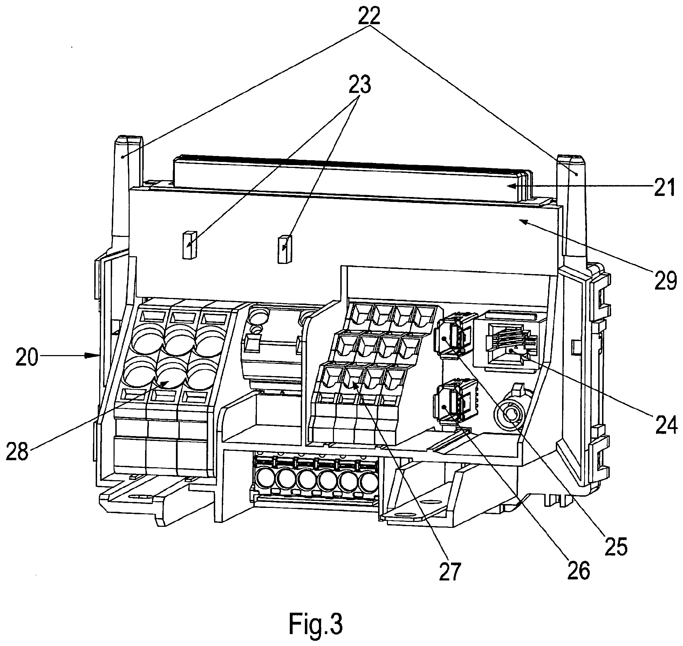

In der Figur 3 ist das Aufnahmeteil 20 mitsamt auf einer Leiterplatte 50 bestücktem Steckverbinderteil 21 und Buchsen (24, 25, 26) und Anschlusselementen (27, 28) in Schrägansicht dargestellt.

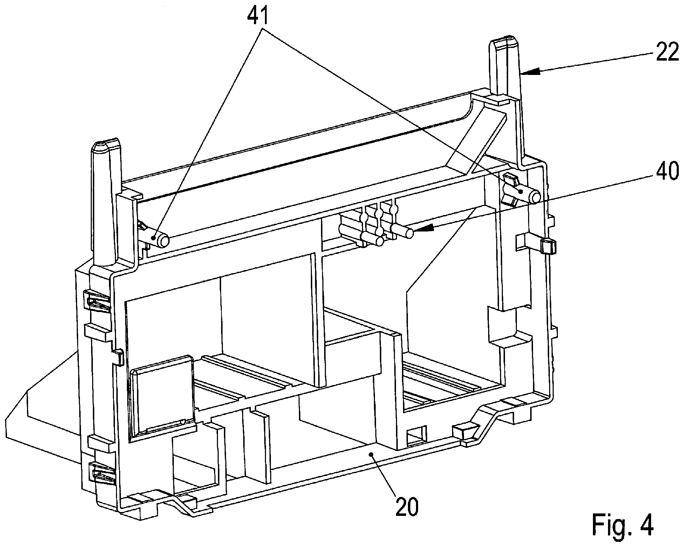

In der Figur 4 ist das Aufnahmeteil 20 alleine in Schrägansicht dargestellt.

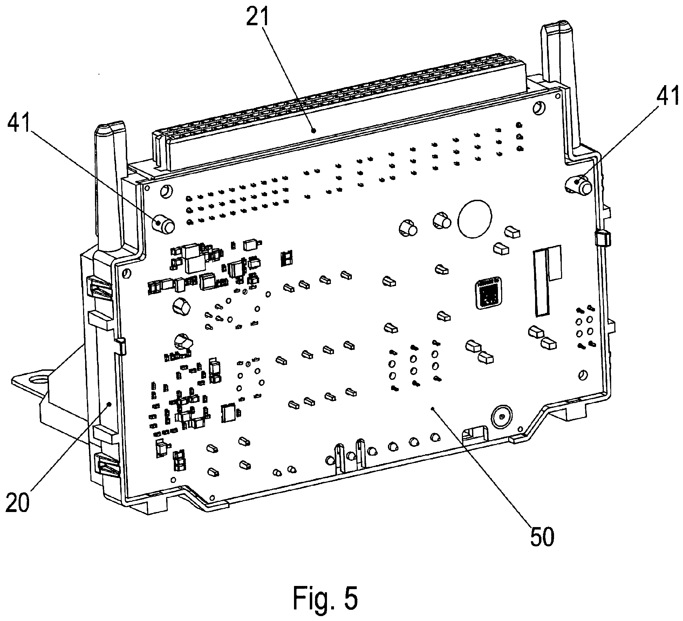

In der Figur 5 ist das Aufnahmeteil 20 samt Leiterplatte 50 aus einer zur Figur 3 unterschiedlichen Blickrichtung dargestellt.

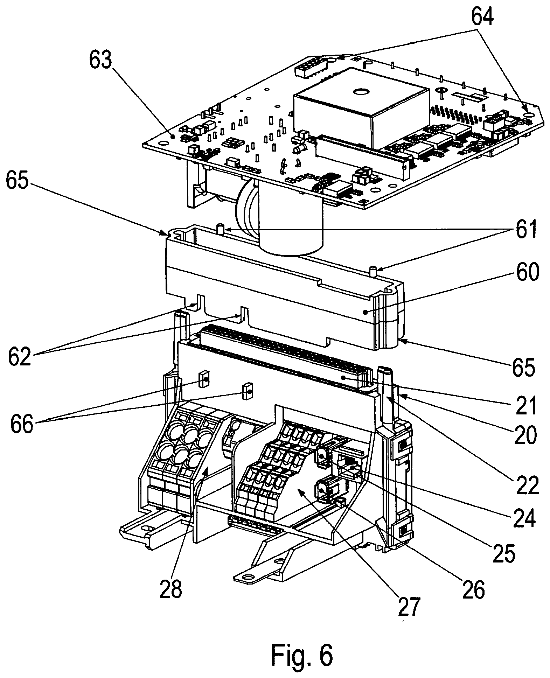

In der Figur 6 ist das Aufnahmeteil 20 und eine mit einem zum Steckverbinderteil 21 entsprechenden Gegensteckverbinderteil und einem Rahmenteil 63, insbesondere Kodierrahmen bestückte Leiterplatte 63, explodiert dargestellt.

Wie in den Figuren gezeigt, weist das erfindungsgemäße Elektrogerät ein Deckelteil 1 auf, in welchem die Leiterplatte 63 angeordnet ist, und ein Anschlussteil 2, in welchem ein Aufnahmeteil 20 angeordnet ist.

Das Aufnahmeteil 20 ist mit dem Anschlussteil 2 kraftschlüssig und/oder formschlüssig verbunden. Insbesondere umgibt das Anschlussteil 2 das Aufnahmeteil 20 gehäusebildend.

Die Leiterplatte 63 ist vorzugsweise mittels Schrauben im Deckelteil 1 befestigt. Insbesondere sind die Schrauben hierbei ins Deckelteil 1 zumindest teilweise eingeschraubt.

Die Leiterplatte 50 ist mit einem Steckverbinderteil 21 bestückt, welches beim Aufsetzen des Deckelteils 1 auf das Anschlussteil 2 steckverbindbar ist mit einem entsprechenden Gegensteckverbinderteil, welches auf der Leiterplatte 63 bestückt ist.

Außerdem ist die Leiterplatte 50 mit Buchsen (24, 25, 26) und Anschlusselementen (27, 28) bestückt, so dass innerhalb des Anschlussteils 2 Versorgungsleitungen mit Anschlusselementen 28 verbindbar sind, deren Kontakte mit Kontakten des Steckverbinderteils 21 verbunden sind und somit eine Versorgung der elektronischen Schaltung im Deckelteil 1 ermöglichen.

Die die Leiterplatte 63 umfassende elektronische Schaltung fungiert vorzugsweise als Umrichter, welcher einen Elektromotor speist. Somit ist der Elektromotor mittels des drehstromgespeisten Umrichters drehzahlsteuerbar oder drehzahlregelbar. Die Anschlussleitungen des Elektromotors sind in das Anschlussteil 2 durch eine Kabelverschraubung hineingeführt und dort mit Anschlusselementen 28 verbunden, so dass aus der elektronischen Schaltung der Elektromotor über Kontakte des Steckverbinderteils 21 versorgbar ist.

Die Drehstromleitungen sind mit Anschlusselementen 28 verbunden, welche über Kontakte des Steckverbinderteils 21 die elektronische Schaltung versorgen.

Die Leiterplatte 63 samt der auf ihr bestückten Steckverbinderteils 21 und der Buchsen (24, 25, 26) für die Kommunikationsleitungen und der samt den Anschlusselementen (27, 28) ist angeschraubt am Aufnahmeteil 20.

Am Aufnahmeteil 20 sind Führungsnasen 22 ausgeformt, welche als voreilende Führung fungieren. Somit ist beim Aufsetzen des Deckelteils 1 auf das Anschlussteil 2 ein Verkanten vermeidbar und die Steckverbindung zwischen Steckverbinderteil 21 und Gegensteckverbinderteil ein geführtes Verbinden ermöglicht, wobei durch die am Aufnahmeteil 20 zum Deckelteil hervorragend ausgeformten Führungsnasen 22 zuerst die Führung aktiviert und danach ein Steckverbinden bewirkt wird.

Auf das Aufnahmeteil 20 samt des Steckverbinderteils 21 ist ein Rahmenteil 60 aufgesetzt, welches das Steckverbinderteil 21 umgibt. Am Rahmenteil 60 sind Codiernasen 61 ausgeformt, welche in Ausnehmungen 64 der Leiterplatte 63 hineinragen. Somit ist eine Kodierung ermöglicht.

Auf der zum Aufnahmeteil 20 zugewandten Seite des Rahmenteils 60 sind Codierschlitze 62 im Rahmenteil 60 vorgesehen, mit denen das Rahmenteil 60 auf Codiernasen 66 aufgesteckt ist.

Wie auch durch die gegenseitige Beabstandung der Ausnehmungen 64 ist durch die gegenseitige Beabstandung der Codiernasen 66 sowie der Schlitze 62 ist eine Kodierung ermöglicht.

Da das Elektrogerät aus einem Baukasten hergestellt wird, welcher zumindest zwei unterschiedliche Leiterplatten 63 und zumindest zwei unterschiedliche Aufnahmeeinheiten 20 enthält, lassen erfindungsgemäße Kodierungen nur das Verbinden der eineindeutig zugeordneten Einheiten bzw. Leiterplatten 63 zu.

Bei der Bestückung der Leiterplatte 63 wird das Rahmenteil 60 zusätzlich auf der Leiterplatte 63 bestückt. Dabei wird das Rahmenteil 60 auf die Leiterplatte 63 derart aufgesetzt, dass die Codiernasen 61 in die Ausnehmungen 64 der Leiterplatte 63 hineinragen. Somit ist nur das zur Leiterplatte 63 zugeordnete, also richtig kodierte Rahmenteil 60 bestückbar. Ähnliche Rahmenteile 60 mit anderer Beabstandung der Codiernasen 61 passen nicht und sind daher nicht bestückbar.

Auf diese Weise ist das Rahmenteil 60 eindeutig zugeordnet zu der Leiterplatte 63.

Beim Aufsetzen des Deckelteils 1 auf das Anschlussteil 2 kommt zuerst das Rahmenteil 60, insbesondere seine Führungsnuten 65, mit den Führungsnasen 22, insbesondere also mit der voreilenden Führung, in Kontakt. Auf diese Weise ist ein geführtes Verbinden ermöglicht und ein Verkanten verhindert.

Das Aufnahmeteil 20 selbst wiederum weist aber auch Codiernasen 40 und 41 auf, welche in Ausnehmungen der Leiterplatte 50 hineinragen beziehungsweise hindurchragen.

Somit ist durch die Codiernasen (40, 41) des Aufnahmeteils 20 die korrekte Zuordnung der Leiterplatte 50 zum Aufnahmeteil 20 gesichert. Auch hier erhöht also die Kodierung die sichere Zuordnung und verhindert somit Fehler beim Zusammenstellen der zu kombinierenden Elemente des Baukastens, insbesondere der zu kombinierenden Aufnahmeteile und Leiterplatten.

Die Codiernasen 40 und 41 ragen an einer ersten Seite des Aufnahmeteils 20 seitlich hervor. Die Codiernasen 66 ragen hingegen an der gegenüberliegenden Seite des Aufnahmeteils 20 hervor.

Insgesamt ist also die Verbindung zwischen Leiterplatte 50 und Aufnahmeteil 20 kodiert sowie die Verbindung zwischen Aufnahmeteil 20 und Rahmenteil 60. Außerdem ist auch die Verbindung zwischen Leiterplatte 63 und Rahmenteil 60 kodiert.

Anders ausgedrückt, ist also die Leiterplatte 50 mit dem Aufnahmeteil 20 kodiert verbunden sowie das Aufnahmeteil 20 mit dem Rahmenteil 60. Außerdem ist auch die Leiterplatte 63 mit dem Rahmenteil 60 kodiert verbunden.

Die Zuleitung der Versorgungsleitungen und Datenleitungen von außen durch die Kabelverschraubungen 3 ist mittels Hybridkabel oder mittels separatem Drehstromkabel und Datenkabel ausführbar. Alternativ ist auch nur ein Drehstromkabel ins Anschlussteil durch die Kabelverschraubung 3 durchführbar und die Datenleitungen über die am Deckelteil 1 zu Verfügung stehende Buchse 4 zuleitbar, wenn der entsprechende Verschlussdeckel der Buchse 4 entfernt ist.

Bei weiteren erfindungsgemäßen Ausführungsbeispielen werden die Kodiermittel, wie Codiernasen und Schlitze beziehungsweise Ausnehmungen vertauscht. Alternativ sind auch Klipsverbindungen verwendbar. In jedem Fall ist aber bei der Verbindung einer ersten Einheit mit einer zweiten Einheit, an der ersten Einheit ein Kodiermittel und an der zweiten Einheit ein korrespondierendes Kodiermittel angeordnet. Somit ist dann die Verbindung kodiert.

### Bezugszeichenliste

1 Deckelteil
2 Anschlussteil
3 Kabelverschraubung für Versorgungskabel und/oder Hybridkabel
4 Buchsenteil mit Verschlusskappe
20 Aufnahmeteil
21 Steckverbinderteil
22 Führungsnase, insbesondere voreilende Führung
23 Codiernase
24 Buchse für Datenübertragung
25 Buchse für Datenübertragung
26 Buchse für Datenübertragung
27 Anschlusselement für Signalleitungen
28 Anschlusselement für Versorgungsleitungen, insbesondere Drehstromleitungen
40 Codiernase
41 Codiernase
50 Leiterplatte
60 Rahmenteil, insbesondere Kodierrahmen
61 Codiernase
62 Codierschlitz
63 Leiterplatte
64 Ausnehmung
65 Führungsnut
66 Codiernasen

## Patentansprüche

1. Elektrogerät, aufweisend ein Anschlussteil und ein mit dem Anschlussteil verbundenes Deckelteil, insbesondere ein auf das Anschlussteil aufgesetztes und verbundenes Deckelteil,
**wobei** im Anschlussteil ein Aufnahmeteil aufgenommen und angeordnet ist, wobei mit dem Aufnahmeteil eine erste Leiterplatte kodiert verbunden ist,
wobei im Deckelteil eine zweite Leiterplatte angeordnet ist, welche mit einem Rahmenteil kodiert verbunden, insbesondere bestückt, ist,
wobei die erste Leiterplatte mit einem Steckverbinderteil verbunden, insbesondere bestückt, ist,
wobei die zweite Leiterplatte mit einem Gegensteckverbinderteil verbunden, insbesondere bestückt, ist,
wobei am Aufnahmeteil eine voreilende Führung für eine Steckverbindung ausgeformt ist, die beim Verbinden des Deckelteils mit dem Anschlussteil wirksam wird, insbesondere das Deckelteil beim Aufsetzen auf das Anschlussteil führt, bevor das Steckverbinderteil mit dem Gegensteckverbinderteil in Kontaktverbindung kommt,
wobei das Rahmenteil kodiert verbindbar ist, insbesondere verbunden ist, mit dem Aufnahmeteil,
**dadurch gekennzeichnet, dass**
**das Aufnahmeteil an einer ersten Seite des Aufnahmeteils hervorstehende Codiernasen aufweist und an der zur ersten Seite gegenüberliegenden Seite hervorstehende Codiernasen aufweist.**

2. Elektrogerät nach Anspruch 1,
**dadurch gekennzeichnet, dass**
die kodierten Verbindungen jeweils durch mit Ausnehmungen, wie Schlitze oder Löcher, in Wirkverbindung stehende Codiernasen gebildet sind.

3. Elektrogerät nach einem der vorangegangenen Ansprüche,
**dadurch gekennzeichnet, dass**
**die Codiernasen jeweils quer zur Steckverbindungsrichtung derjenigen Steckverbindung am Aufnahmeteil hervorragen, welche das Steckverbinderteil und das Gegensteckverbinderteil aufweist.**

4. Elektrogerät nach einem der vorangegangenen Ansprüche,
**dadurch gekennzeichnet, dass**
die voreilende Führung als am Aufnahmeteil hervorragende Führungsnase ausgeformt ist.

5. Elektrogerät nach einem der vorangegangenen Ansprüche,
**dadurch gekennzeichnet, dass**
zur kodierten Verbindung des Aufnahmeteils mit der ersten Leiterplatte am Aufnahmeteil Codiernasen ausgeformt sind, welche in oder durch Ausnehmungen der ersten Leiterplatte ragen.

6. Elektrogerät nach einem der vorangegangenen Ansprüche,
**dadurch gekennzeichnet, dass**
zur kodierten Verbindung des Rahmenteils mit der zweiten Leiterplatte an dem Rahmenteil Codiernasen ausgeformt sind, welche in oder durch Ausnehmungen der zweiten Leiterplatte ragen.

7. Elektrogerät nach einem der vorangegangenen Ansprüche,
**dadurch gekennzeichnet, dass**
zur kodierten Verbindung des Rahmenteils mit dem Aufnahmeteil am Aufnahmeteil Codiernasen ausgeformt sind, welche in Schlitze des Rahmenteils hineinragen.

8. Elektrogerät nach einem der vorangegangenen Ansprüche,
**dadurch gekennzeichnet, dass**
das Rahmenteil und das Aufnahmeteil jeweils als Kunststoffspritzgussteil gefertigt sind.

9. Elektrogerät nach einem der vorangegangenen Ansprüche,
**dadurch gekennzeichnet, dass**
das Elektrogerät ein Umrichter ist und/oder einen Wechselrichter aufweist, der einen Elektromotor speist, an dem das Anschlussteil befestigt ist.

10. Elektrogerät nach einem der vorangegangenen Ansprüche,
**dadurch gekennzeichnet, dass**
eine im Deckelteil auf der zweiten Leiterplatten angeordneten elektronischen Schaltung als Umrichter, insbesondere als elektronische Schaltung eines Umrichters oder Wechselrichters, fungiert,
insbesondere welcher mittels ins Anschlussteil geführter Drehstromleitungen gespeist ist und dessen einen Elektromotor speisender elektrischer Anschluss über Kontakte des Steckverbinderteils und aus dem Anschlussteil herausgeführte, zum Elektromotor geführte Leitungen mit dem Anschluss des Elektromotors elektrisch verbunden ist.

## Claims

1. Electrical device comprising a connection part and a lid part connected to the connection part, in particular a lid part that is placed on the connection part and connected thereto,
a receiving part being received and arranged in the connection part, a first printed circuit board being connected to the receiving part in a coded manner,
a second printed circuit board that is connected to, in particular fitted with, a frame part in a coded manner being arranged in the lid part,
the first printed circuit board being connected to, in particular fitted with, a plug connector part,
the second printed circuit board being connected to, in particular fitted with, a mating plug connector part,
a leading guide for a plug connection being formed on the receiving part, said leading guide becoming active during the connecting of the lid part to the connection part, in particular guiding the lid part when it is being placed on the connection part, before the plug connector part establishes a contact connection to the mating plug connector part,
the frame part being connectable, in particular connected, to the receiving part in a coded manner,
**characterised in that**
the receiving part has coding lugs protruding on a first side of the receiving part as well as coding lugs protruding on the opposite side to the first side.

2. Electrical device according to claim 1,
**characterised in that**
the coded connections are each formed by coding lugs operatively connected to openings, such as slots or holes.

3. Electrical device according to any of the preceding claims,
**characterised in that**
the coding lugs each project on the receiving part transversely to the plug connection direction of the plug connection having the plug connector part and the mating plug connector part.

4. Electrical device according to any of the preceding claims,
**characterised in that**
the leading guide is formed as a guide lug projecting on the receiving part.

5. Electrical device according to any of the preceding claims,
**characterised in that**
in order to connect the receiving part to the first printed circuit board in a coded manner, coding lugs which project into or through openings in the first printed circuit board are formed on the receiving part.

6. Electrical device according to any of the preceding claims,
**characterised in that**
in order to connect the frame part to the second printed circuit board in a coded manner, coding lugs which project into or through openings in the second printed circuit board are formed on the frame part.

7. Electrical device according to any of the preceding claims,
**characterised in that**
in order to connect the frame part to the receiving part in a coded manner, coding lugs which project into slots in the frame part are formed on the receiving part.

8. Electrical device according to any of the preceding claims,
**characterised in that**
the frame part and the receiving part are each produced as a plastics injection-moulded part.

9. Electrical device according to any of the preceding claims,
**characterised in that**
the electrical device is a converter and/or has an inverter that feeds an electric motor to which the connection part is fastened.

10. Electrical device according to any of the preceding claims,
**characterised in that**
an electronic circuit arranged on the second printed circuit board in the lid part operates as a converter, in particular as an electronic circuit of a converter or of an inverter, which in particular is fed by means of three-phase lines led into the connection part and of which the electrical terminal feeding an electric motor is electrically connected to the terminal of the electric motor by means of contacts of the plug connector part and lines leading out of the connection part towards the electric motor.

## Revendications

1. Appareil électrique, présentant une partie raccordement et une partie couvercle reliée à la partie raccordement, en particulier une partie couvercle mise en place sur la partie raccordement et reliée à celle-ci,
une partie accueil étant accueillie et agencée dans la partie raccordement, une première carte de circuit imprimé étant reliée de manière codée à la partie accueil, une seconde carte de circuit imprimé reliée de manière codée à une partie cadre, en particulier équipée de ladite partie cadre, étant agencée dans la partie couvercle,
la première carte de circuit imprimé étant reliée à une partie connecteur enfichable, en particulier étant équipée de ladite partie connecteur enfichable,
la seconde carte de circuit imprimé étant reliée à une partie connecteur enfichable homologue, en particulier étant équipée de ladite partie connecteur enfichable homologue,
un guidage anticipé destiné à une connexion enfichable étant formé au niveau de la partie accueil, lequel guidage anticipé agit lors de la connexion de la partie couvercle à la partie raccordement, en particulier guide la partie couvercle lors de la mise en place sur la partie raccordement avant que la partie connecteur enfichable n'entre en contact avec la partie connecteur enfichable homologue,
la partie cadre pouvant être reliée, en particulier étant reliée, de manière codée à la partie accueil,
**caractérisé en ce que**
la partie accueil présente des ergots de codage saillants sur un premier côté de la partie accueil et des ergots de codage saillants sur le côté opposé au premier côté.

2. Appareil électrique selon la revendication 1,
**caractérisé en ce que**
les connexions codées sont formées respectivement par des ergots de codage en liaison active avec des évidements, tels que des fentes ou des trous.

3. Appareil électrique selon l'une quelconque des revendications précédentes, **caractérisé en ce que**
les ergots de codage font saillie respectivement de manière transversale par rapport à la direction de connexion par enfichage de la connexion enfichable, située au niveau de la partie accueil, qui présente la partie connecteur enfichable et la partie connecteur enfichable homologue.

4. Appareil électrique selon l'une quelconque des revendications précédentes, **caractérisé en ce que**
le guidage avancé est réalisé sous la forme d'un ergot de guidage faisant saillie au niveau de la partie accueil.

5. Appareil électrique selon l'une quelconque des revendications précédentes, **caractérisé en ce que**
en vue d'une connexion codée de la partie accueil avec la première carte de circuit imprimé, des ergots de codage faisant saillie dans ou à travers des évidements de la première carte de circuit imprimé sont réalisés au niveau de la partie accueil.

6. Appareil électrique selon l'une quelconque des revendications précédentes, **caractérisé en ce que**
en vue d'une connexion codée de la partie cadre avec la seconde carte de circuit imprimé, des ergots de codage faisant saillie dans ou à travers des évidements de la seconde carte de circuit imprimé sont réalisés au niveau de la partie cadre.

7. Appareil électrique selon l'une quelconque des revendications précédentes, **caractérisé en ce que**
en vue d'une connexion codée de la partie cadre avec la partie accueil, des ergots de codage faisant saillie dans des fentes de la partie cadre sont réalisés au niveau de la partie accueil.

8. Appareil électrique selon l'une quelconque des revendications précédentes, **caractérisé en ce que**
la partie cadre et la partie accueil sont respectivement fabriquées sous forme de pièce moulée par injection de plastique.

9. Appareil électrique selon l'une quelconque des revendications précédentes, **caractérisé en ce que**
l'appareil électrique est un convertisseur et/ou présente un onduleur qui alimente un moteur électrique auquel la partie raccordement est fixée.

10. Appareil électrique selon l'une quelconque des revendications précédentes, **caractérisé en ce que**
un circuit électronique agencé dans la partie couvercle sur la seconde carte de circuit imprimé fait office de convertisseur, en particulier de circuit électronique d'un convertisseur ou d'un onduleur,
lequel est en particulier alimenté par des lignes triphasées guidées dans la partie raccordement et
dont le raccordement électrique alimentant un moteur électrique est relié électriquement au raccordement du moteur électrique par l'intermédiaire de contacts de la partie connecteur enfichable et de lignes guidées hors de la partie raccordement et guidées vers le moteur électrique.
